# EUROPEAN PATENT SPECIFICATION

(11) **EP 0 644 577 B1**
(45) Date of publication and mention of the grant of the patent: **10.09.1997**
(21) Application number: 94108878.3
(22) Date of filing: 09.06.1994
(51) Int. Cl.: H01L 21/00

(54) **Treating method and treating apparatus for treated object under reduced pressure environment**
Verfahren und Einrichtung zur Bearbeitung eines Gegenstands in einer Umgebung unter vermindertem Druck
Méthode et dispositif de traitement d'un objet en environnement à pression réduite

(30) Priority: 16.09.1993 JP 230186/93
(43) Date of publication of application: 22.03.1995
(73) Proprietor: HITACHI, LTD., Chiyoda-ku, Tokyo 101 (JP)
(72) Inventor: Ito, Youichi, Kudamatsu-shi, Yamaguchi 744 (JP); Edamura, Manabu, Niihari-gun, Ibaraki 315 (JP); Tamura, Naoyuki, Kudamatsu-shi, Yamaguchi 744 (JP); Shichida, Hiroyuki, Kudamatsu-shi, Yamaguchi 744 (JP)
(74) Representative: Altenburg, Udo, Dipl.-Phys.

(56) References cited:
- EP-A- 0 260 150
- EP-A- 0 469 469
- EP-A- 0 513 834
- US-A- 5 213 349
- IBM TECHNICAL DISCLOSURE BULLETIN., vol.31, no.1, June 1988, NEW YORK US pages 462 - 464, XP119644 'ELECTROSTATIC WAFER HOLDER FOR WAFER COOLING DURING REACTIVE ION ETCHING'

## Description

### Background of the Invention

### Field of the Invention

The present invention relates to an apparatus and method for treating a wafer, such as treating a wafer with plasma, in a reduced pressure environment, wherein it is easy to perform temperature control of the wafer and which is suitable for a simplified electrode construction.

### Description of the Related Art

Treating a wafer in a reduced pressure environment is a widely used technique in semiconductor chip production. A great variety of apparatus and methods are known to achieve such wafer treatment.

A first category of prior art proposes an electrostatic wafer holder for wafer cooling during plasma treating or reactive ion etching, as described, for example, in the IBM Technical Disclosure Bulletin Vol. 31, No. 1, June 1988, pp. 462-464, or in the JP Patent Publications No. 56-53853 (1981) and 57-44747 (1982). The wafer is electrostatically adhered to a pedestal having an electrostatic adhering electrode, and at the same time cooled by supplying helium gas to the backside surface of the wafer for cooling the wafer during treatment.

A second category of prior art proposes to mechanically hold the wafer on a pedestal using a clamp during processing while the wafer is being cooled by introducing helium gas on the bottom surface of the wafer with heat conduction, as described, for example, in the EP Patent Application No. 469 469, and JP Patent Publication No. 2-27778 (1990) and JP Patent Application Laid-Open No. 2-30128 (1990). EP-A-469 469 also describes an electrode whose surface is coated with an anodic oxide film of about 10 to 200 µm, and then further covered with an elastic insulating film of about 25 to 100 µm thickness, such as polyimide resin film, capton film or the like using acrylic adhesive (thickness of 10 to 15 µm). The purpose of covering the electrode with the elastic insulating film is for keeping the impedance between the wafer and the electrode constant.

A third category of prior art proposes a wafer cooling apparatus wherein a pedestal disposed within the treatment chamber receives the wafer which is lowered mechanically onto an upper surface of the pedestal. This upper surface of the pedestal is grooved to allow gas trapped between the wafer and the pedestal surface to escape around the periphery of the wafer, thereby minimizing the tendency of tne wafer to "skate" across the surface of the pedestal on a thin layer of gas. Gas which is trapped between the wafer and the pedestal is forced into the grooves of the pedestal. Such an apparatus is described, for example, in the EP Patent Application No. 513 834. The gas which is forcibly injected into said grooves is ejected to the treatment chamber through the periphery.

A fourth category of prior art for the electrostatic adhering embodiment to provide an electrode with a diameter larger than the diameter of the wafer, as described, for example, in the JP Patent Application Laid-Open No. 63-300517 (1988).

The above prior art embodiments have a number of disadvantages when they are applied to successive wafer treatment by etching, plasma or the like.

In the first category of prior art the wafer cannot be cooled sufficiently when the heat transfer between the wafer and the pedestal is performed by solid-solid contact only. In the method where the wafer is treated while a cooling gas is being introduced onto the bottom surface of the wafer, it is necessary to provide a helium gas supplying system to the electrode on the pedestal without fail. Pressure gas control is complex since the pressure on the bottom surface needs to be controlled by means of finely adjusting the in-flow and out-flow rates of the cooling gas alternately in order to control the temperature of the wafer under treatment. In addition, the mechanical design and structure of the apparatus is also complex because it is required to provide the pedestal with means for introducing the cooling gas.

There is an additional problem in that the temperature rise at the central part of the wafer becomes larger than the peripheral part, and the temperature distribution across the wafer becomes non-uniform since the peripheral part of the wafer is not adhered to the electrode, thus being in a vacuum adiabatic state and is thus not cooled. This effect becomes substantially large when the heat input to the wafer increases and the diameter of the wafer increases.

The embodiment of the third prior art category where grooves are provided on the surface of the pedestal the cooling gas escapes from the grooves to the treatment chamber because of the open, unsealed wafer periphery, so that there is a constant flow and supply of cooling gas wherein the gas pressure is the same in the grooves and the treatment chamber.

The embodiment of the fourth prior art category encounters a problem in that a stable adhering force cannot be obtained and the life of the insulating film becomes short since the diameter of the electrode is larger than that of the wafer, and the insulating film in the part not adhering the wafer is, therefore, etched and scaped by the plasma.

It is, therefore, an object of this invention to overcome the deficiencies observed in the prior art embodiments for treating a wafer in a reduced pressure environmemt.

It is a more specific object to provide an apparatus and method for treating a wafer in a reduced pressure environment wherein the temperature control of the treated wafer is easily performed and the construction of the wafer receiving pedestal and of its electrode is simplified.

It is a further object of this invention to provide an apparatus for electrostatically adhering a wafer to the electrode of the pedestal providing a suitable temperature distribution across the wafer to be cooled and to be heat-treated with plasme or the like.

### Summary of the Invention

These and other objects and advantages of the invention in the processing and treatment of a wafer in a reduced pressure environment are achieved in an apparatus according to the characteristic features and elements of claim 1. The method for treating a wafer in a reduced pressure environment according to this invention is achieved by the characterizing steps of claim 15. Further enhancements are provided by the subclaims.

The above objects can be attained by electrostatically adhering and fixing a wafer to a pedestal or specimen table afer the wafer is mounted on the pedestal in an environment of a treating system or a spare chamber or a treating chamber wherein a gaseous medium is introduced and its pressure controlled to the effect that that the cooling gas pressure is maintained higher than the wafer treating pressure which is maintained in the treating chamber. The gaseous medium may be a process gas or may be a high heat conductive gas such as helium.

The further object described above can be attained by means of producing a distribution in the heat transfer coefficient between the wafer and the electrostatic adhering electrode. The following methods can be thought as the method of producing the distribution: forming wafer contact portions and wafer non-contact portions alternately with varying the gap between the wafer and the insulating film; forming large roughness portions and small roughness portions on the surface of the insulating film alternately; and forming the insulating film using different kinds of materials alternately.

According to the present invention, by means of electrostatically adhering a wafer in an environment controlled to a pressure higher than a treating pressure, a gas having a pressure higher than the treating pressure can be enclosed in a space between the wafer and the specimen table. And then the pressure of the treating chamber is controlled to the treating pressure and the wafer is treated. During this time, the gas pressure is gradually decreased since the gas enclosed between the wafer and the specimen table leaks into the treating chamber through the gap formed by the surface roughness between the treated object and the specimen table. However, by means of adjusting the enclosing pressure and the electrostatic adhering force, it is possible to keep the gas pressure high enough to produce a sufficient heat transfer coefficient for cooling or heating the wafer during treatment.

An explanation will be given next on a case where the gap between the wafer and the electrostatic adhering electrode is varied alternately to form contact portions and non-contact portions on the wafer. The heat transfer coefficient between the wafer and the electrode is high at the contact portions on the wafer and low at the non-contact portions on the wafer. Therefore, the temperature of the wafer is low at the center of the contact portion and high at the center of non-contact portion. Since the temperature distribution in the wafer falls within the difference between the highest temperature at the center of the wafer contact portion and the lowest temperature at the center of the wafer non-contact portion, the temperature in the periphery is prevented from solely rising higher compared to the temperature at the center and from forming a non-uniform temperature distribution as observed in a conventional apparatus. Thus a uniform temperature distribution can be obtained. On addition to this, since the heat transfer coefficient depends on the electrostatic adhering force, the same effect can be obtained by means of varying the surface roughness of the insulating film alternately or by means of varying the kinds of materials of the insulating film.

### Brief Description of the Drawings

FIG.1 is a view showing the construction of an etching apparatus to which a first embodiment in accordance with the present invention is applied.

FIG.2 is a view showing the construction of an etching treating chamber to which the first embodiment is applied.

FIG.3 is a view showing the construction of a bottom electrode and an electrostatic adhering electrode in the first embodiment.

FIG.4 is a view showing the construction of a bottom electrode and an electrostatic adhering electrode in the first embodiment.

FIG.5 is a chart explaining the etching treatment in the first embodiment.

FIG.6 is a graph showing a relationship between gas pressure and heat transfer coefficient.

FIG.7 is a view showing the construction of an etching treating chamber to which a second embodiment in accordance with the present invention is applied.

FIG.8 is a chart explaining the etching treatment in the second embodiment.

FIG.9 is a view showing the construction of an etching treating chamber to which a third embodiment in accordance with the present invention is applied.

FIG.10 is a view showing the construction of an etching treating chamber to which a fourth embodiment in accordance with the present invention is applied.

FIG.11 is a chart explaining the etching treatment in the fourth embodiment.

FIG.12 is a view showing the construction of anther etching apparatus to which a fifth embodiment in accordance with the present invention is applied.

FIG.13 is a view showing the construction of a spattering apparatus to which a sixth embodiment in accordance with the present invention is applied.

FIG.14 is a view showing the construction of a spattering apparatus to which a seventh embodiment in accordance with the present invention is applied.

FIG.15 is a cross-sectional view being taken on the plane of the line A-A in FIG.14.

FIG.16 is a plan view of an electrostatic adhering electrode to which an eighth embodiment in accordance with the present invention is applied.

FIG.17 is a side view of the electrostatic adhering electrode in FIG.16.

FIG.18 is a graph showing calculated results of the heat transfer coefficient in the embodiment in FIG.16.

FIG.19 is a graph showing calculated results of temperature distribution across the wafer in the embodiment in FIG.16.

### Detailed Description of the Preferred Embodiments

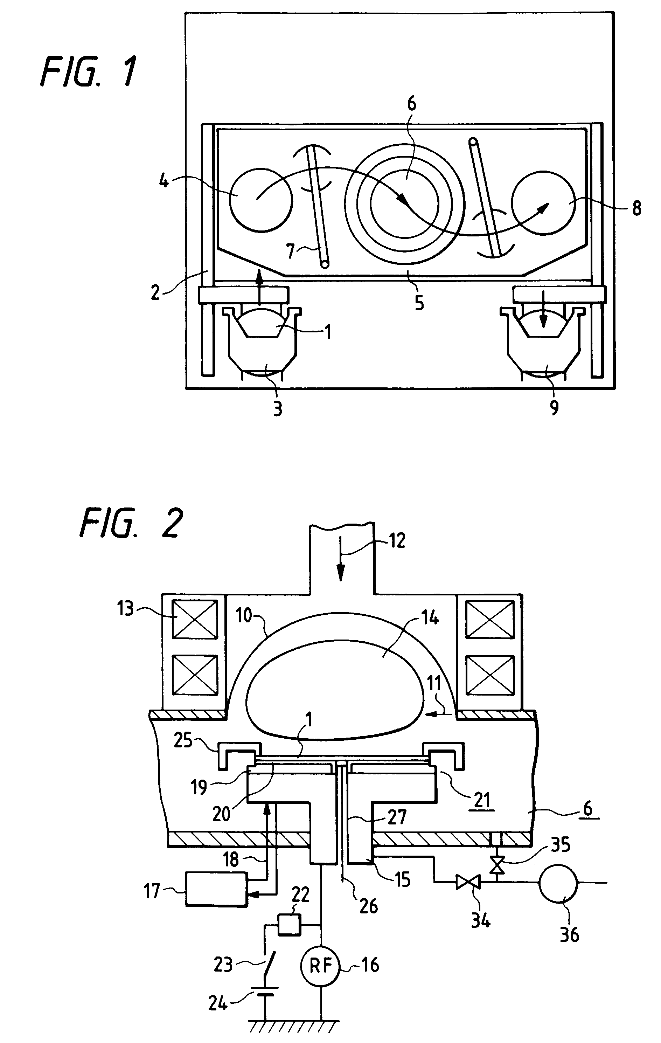

Description will be made below on the construction of a microwave etching apparatus with magnetic field to which a first embodiment according to the present invention is applied, referring to FIG.1 to FIG.4. Firstly, transfer of a wafer 1 will be described below referring to FIG.1. The wafer 1 is take out of a load cassette 3 using a linear driving arm 2 to be carried into a load lock chamber 4. Then, the wafer 1 carried in the load lock chamber 4 is carried inside a buffer chamber 5, which is vacuum environment, toward a etching treatment chamber 6 using a rotating arm 7. After being etched in a manner to be described later, the wafer 1 is take out to the atmosphere through the buffer chamber and an unload lock chamber 8 to contained into an unload cassette 9.

The etching treatment camber 6 will be described below referring to FIG.2. Etching treatment of the wafer 1 is carried out in such a manner that a given amount of process gas 11 introduced into a discharge tube 10 is formed into plasma 14 with the interaction of magnetic fields cased by microwave 12 and a solenoid coil 13, the energy of ion to be implanted into the wafer 1 being controlled using a bottom electrode 15 applying high frequency current from a high frequency power source 16, the bottom electrode 15 being controlled its temperature by means of circulating a coolant 18 using a circulator 17.

There is provided on the bottom electrode 15 an electrostatic adhering electrode 21 which is constructed by means of forming an insulating film 20 on an aluminum electrode 19. A switch 23 and a direct current power source 24 are connected to the bottom electrode 15 through a low pass filter 22. During etching treating the wafer 1 is held in such a manner that the bottom electrode 15 is lifted up to fix the periphery of the wafer 1 with a wafer clamp 25, plasma 14 being produced in the manner described above, and then the switch 23 is turned on in order to apply direct current to the both sides of the insulating film 20 to produce electrostatic adhering force.

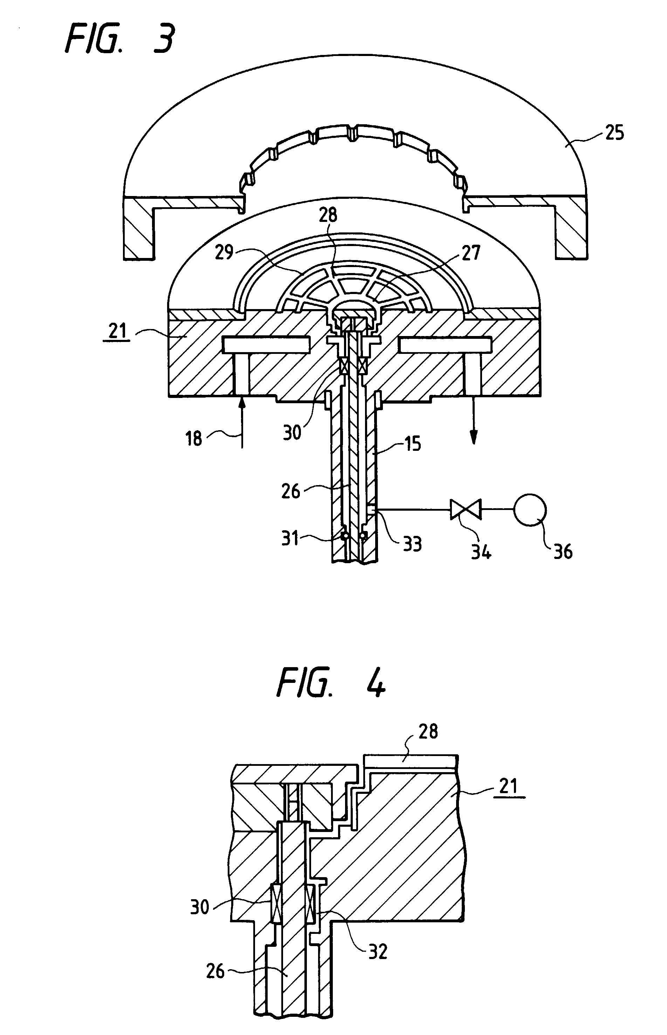

Next, the constructions of the bottom electrode 15 and the electrostatic adhering electrode 21 will be described referring to FIG.3 and FIG.4. A hole 27 is formed in the bottom electrode 15 and the electrostatic adhering electrode 21 at the center of the surface mounting the wafer in the direction of the wafer thickness. A wafer lift-up pin 26 is inserted into the hole to lift up the wafer 1 from the electrostatic adhering electrode 21 in order to transfer the wafer 1.

A plurality of grooves 28 radially extending from the hole 27 and a plurality of ring-shaped grooves 29 connecting the grooves 28 each other are formed on the surface mounting the wafer 1 of the electrostatic adhering electrode 21. These groves 28 and 29 have, for example, a depth of 0.05 to 0.1mm and a width of 0.5 to 1.0mm, and are formed with ultrasonic machining. One end of the wafer lift-up pin 26 is supported with a sliding bearing 30 and the other end is sealed with an O-ring 31. And a plurality of gaps 32 (communicating passages) are provided on the outer surface of the sliding bearing 30. Therewith, when the wafer 1 is not mounted on the electrostatic adhering electrode 21, the space (reservoir) from the grooves 28 and 29 on the electrostatic adhering electrode 21 to the gaps between the wafer lift-up pin 26 and the hole 27 is communicating to the etching chamber 6. The bottom electrode 15 is provided with an exhausting hole 33 which is connected up to the gap between the wafer lift-up pin 26 and the hole 27 in order to evacuate the etching chamber 6 using a vacuum pump 36 through a valve 35 by means of opening a valve 34.

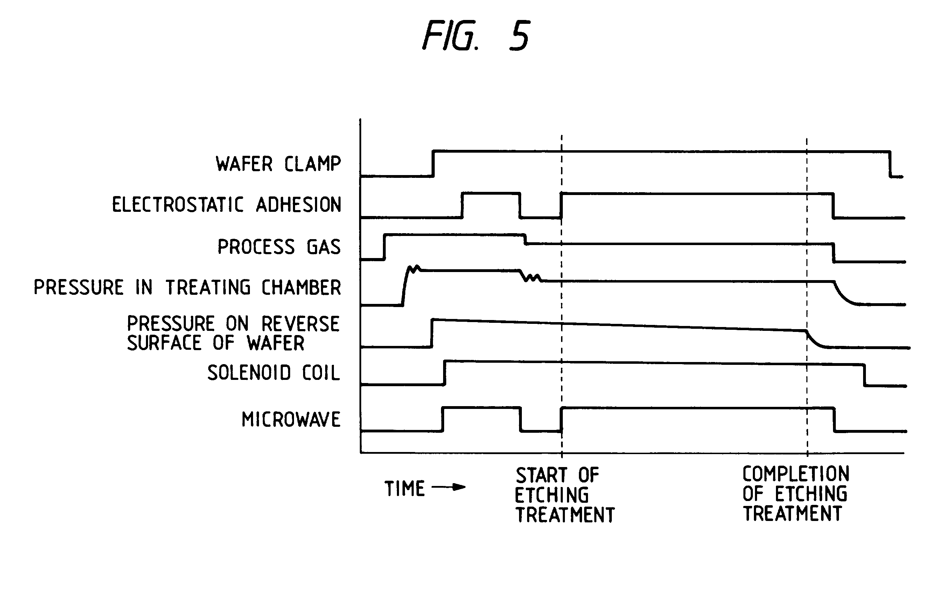

The sequence of etching treatment in a first embodiment according to the present invention will be described below referring to FIG.5. Firstly, the pressure inside the etching treatment chamber is controlled to a certain pressure, for example above 1.33 kPa (10 Torr), by means of pumping while the process gas 11 is being introduced into the etching treatment chamber 6. Therewith, the pressure, in the space (reservoir) from the grooves 28 and 29 on the electrostatic adhering electrode 21 to the gaps between the wafer lift-up pin 26 and the hole 27 which is communicated to the etching treatment chamber 6, becomes above 1.33 kPa ( = 10 Torr). (Note: 1 Torr = 133 Pa (N/cm²).

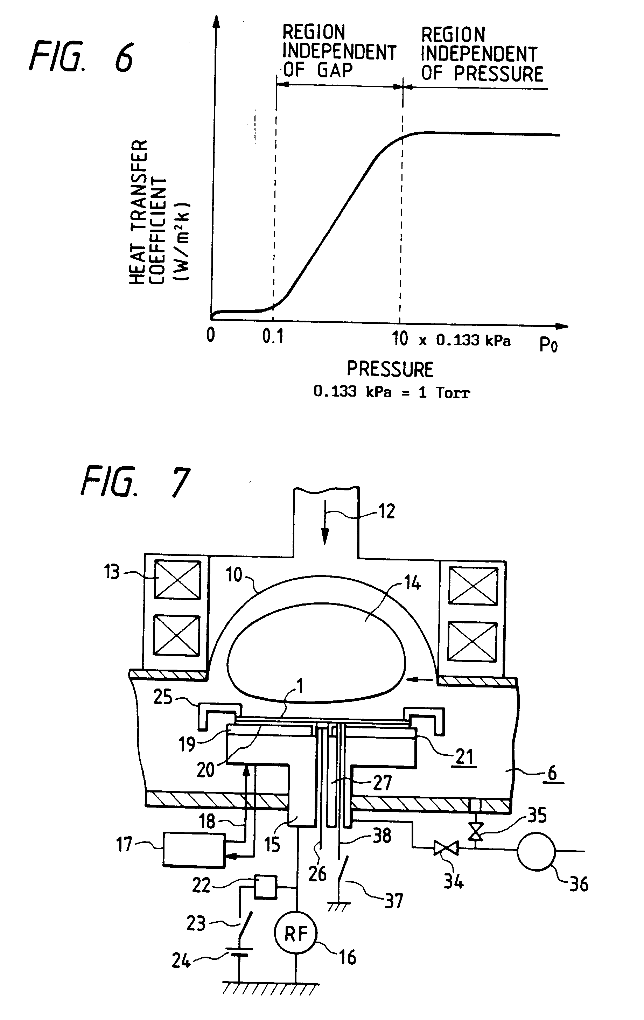

Generally, the relationship between gas pressure and heat transfer coefficient is such a relationship as in helium gas shown as an example in FIG.6, the heat transfer coefficient does not depend on the pressure and has a constant value in the range from several Torrs to approximately 10 Torrs. On the other hand, the treating pressure is approximately 0.01 Torr for etching or chemical vapor deposition, and approximately 0.1 Torr for spattering, 1/10⁵ to 1/10⁷ Torr for ion implanting, and approximately 1/10¹⁰ Torr for molecular beam epitaxy. Therefore, a stable and high heat transfer coefficient can be obtained when the pressure is higher than the treating pressure, that is above 0.1 Torr or preferably approximately above 10 Torr.

The wafer 1 is transferred to the etching treatment chamber 6 using the rotating arm 7 under such a gas pressure higher than the treating pressure, the wafer lift-up pin 26 being raised to lift up the wafer 1, the rotating arm 7 being rotated to the load lock chamber 4 side, and then the wafer lift-up pin 26 is lowered. Therewith, the wafer 1 is mounted on the electrostatic adhering electrode 21.

The bottom electrode 15 is raised to hold the periphery of the wafer 1 with the wafer clamp 25. Under this condition, the plasma 13 is generated by turning on the microwave 12 and the solenoid coil 13, and the switch 23 is turned on to electrostatically adhere the wafer 1 onto the electrostatic adhering electrode 21. By doing this, The process gas having a pressure above approximately 10 Torr is enclosed in the reservoir that is the space from the grooves 28 and 29 on the electrostatic adhering electrode 21 to the gap between the wafer lift-up pin 26 and the hole 27, and the pressure in the reverse side of the wafer 1 is approximately 10 Torr.

After the microwave 12 is turned off for a moment to eliminate the plasma 14 and the switch 23 is turned off, the pumping rate of the process gas 11 from the inside of the etching treatment chamber 6 is increased and the pressure is controlled to the etching treatment pressure which is lower than the pressure at the beginning. During this time, the wafer 1 is held with the residual adhering force, the process gas 11 existing in the space from the grooves 28 and 29 on the electrostatic adhering electrode 21 to the gap between the wafer lift-up pin 26 and the hole 27 being leaking to the etching treatment chamber 6 through the gap having a width of surface roughness between the reverse side surface of the periphery of the wafer 1 and the peripheral surface of the electrostatic adhering electrode 21, and the process gas 11 excluding this leaked amount is enclosed in the gap.

Next, the microwave 12 is again turned on to produce plasma and the switch 23 is turned on, then the wafer is given the adhering force to be treated under this condition. During etching treatment of the wafer 1, the process gas in the reservoir, that is the space from the grooves 28 and 29 of the electrostatic adhering electrode 21 to the gap between the wafer lift-up pin 26 and the hole 27, is leaking due to the pressure difference between in the etching treatment chamber 6 and in the space. Although the pressure in the space is gradually decreasing, the pressure is kept high enough to be required to maintain the temperature of the wafer 1 at a given temperature during the etching treatment.

After completion of the etching treatment, the process gas 11 in the reservoir, that is the space from the grooves 28 and 29 on the electrostatic electrode 21 to the gap between the wafer lift-up pin 26 and the hole 27, is evacuated by opening the valve 34 using the vacuum pump 36. Then the microwave 12 and the solenoid coil 13 are turn off to eliminate the plasma 14 and the switch 23 is turned off to release the electrostatic adherence force act on the wafer 1. And the bottom electrode 15 is lowered to release the wafer 1 from clamping of the wafer clamp 25.

Table 1 shows a result of an experiment on the temperature change of a wafer 1 during etching treatment in accordance with this etching method.

**Table 1**

| Measured Results of Wafer Temperature Change HEAT INPUT:**6780 W/m**^{**2**} | | | | |
|---|---|---|---|---|
| WAFER BEND (µm) | APPLIED VOLTAGE (V) | PRESSURE ON REVERSE SURFACE BEFORE BEGINNING OF ETCHING (Torr)* | PRESSURE ON REVERSE SURFACE 2 MIN AFTER BEGINNING OF ETCHING (Torr)* | WAFER TEMPERATURE DURING ETCHING (°C) |
| 5 | -300 | 10.4 | 9.2 | 0.6 |
| | -600 | 10.4 | 9.5 | 0.5 |
| 30 | -300 | 10.4 | 6.3 | 2.7 |
| | -600 | 10.4 | 9.4 | 0.4 |

| | | | | |
|---|---|---|---|---|
| * Note: Conversion equation is 1 Torr = 133 Pa (N/cm²) | | | | |

According to the result, when the bending amount (convex shaped) of the wafer 1 is small namely approximately 5 µm and the voltage applied to the electrostatic adhering electrode 21 is above -300V, the temperature change of the wafer 1 during etching treatment is within approximately 1°C and, therefore, a preferable result has been obtained. When the bending amount (convex shaped) of the wafer 1 is large namely approximately 30 µm and the voltage applied to the electrostatic adhering electrode 21 is above -300V, the temperature change of the wafer 1 during etching treatment is approximately 2.7°C. Even in this case, the applied voltage is, however, increased up to -600°C to increase adherence force, the temperature change can be decreased within 1°C and a preferable result has been also obtained. In this time, the heat input to the wafer 1 has been approximately 120W/6inches.

The treatment temperature of the wafer 1 can be set by means of changing the pressure on the reverse side surface of the wafer 1 at the initial period of the electrostatic adherence of the wafer 1 and changing the pressure on the reverse side of the wafer 1 at the beginning of etching treatment. The sufficient repeatability of the temperature of the wafer 1 can be easily obtained by means of providing a pressure gage between the exhausting hole 33 and the valve 34 and controlling the pressure at the beginning of etching treatment at a constant value.

Helium gas instead of the process gas 11 may be used as the gas enclosed in the reservoir that is the space from the grooves 28 and 29 on the electrostatic adhering electrode 21 to the gap between the wafer lift-up pin 26 and the hole 27. In this case, as the first step, the helium gas is introduced into the etching treatment chamber 6. And after completion of electrostatic adherence, the process gas is introduced into the etching treatment chamber 6 instead of helium gas. Then after the pressure is controlled to the etching treatment pressure, etching treatment is performed as described above.

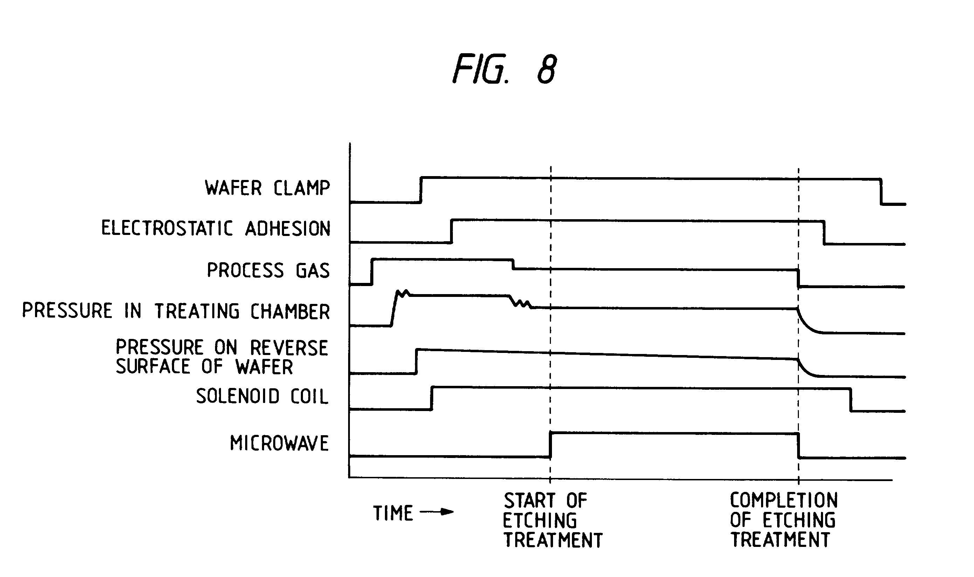

Description will be made below on the construction and etching method of a microwave etching apparatus with magnetic field to which a second embodiment according to the present invention is applied, referring to FIG.7 and FIG.8. The different point in this construction from that in the first embodiment is that the bottom electrode 15 is provided with an electrode 38 which is capable of being switched between the ground and floating state using a switch 37 and contacted to the reverse surface of the wafer 1 when the wafer is mounted on the electrostatic adhering electrode 21. The electrostatic adherence of the wafer 1 is carried out by means of switching on the switch 23 under the condition of switching on the switch 37. And when the etching treatment is started, the switch 37 is turned off to make the electrode 38 to a floating state. By doing this way, the release of electrostatic adherence of the wafer 1 can be eliminated when the pressure inside the etching treating chamber is controlled to the treating pressure before starting the etching treatment as shown in FIG.8, which leads to lessening in pressure decrease on the reverse side surface of the wafer.

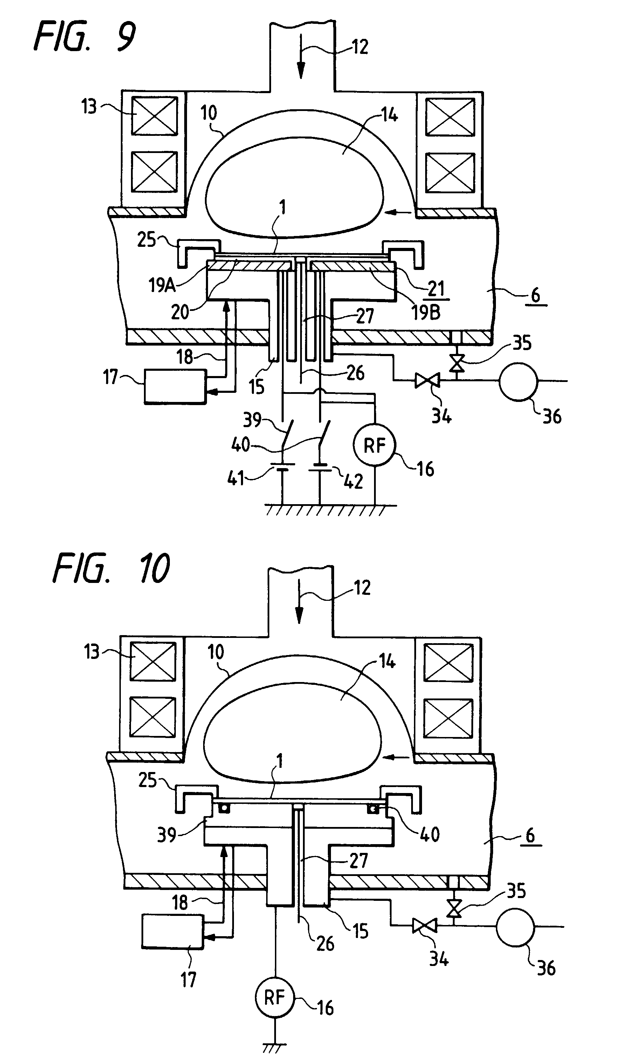

Description will be made below on the construction and etching method of a microwave etching apparatus with magnetic field to which a third embodiment according to the present invention is applied, referring to FIG.9. The different point in this construction from that in the first and the second embodiments is that the electrode 19 in the electrostatic adhering electrode 21 is divided into two parts 19A, 19B insulated from each other, switches 39 and 40 being connected to direct current power sources 41 and 42 so that direct current voltages having the opposite polarities may be applied to the electrodes 19A and 19B each. Adhering of the wafer 1 is performed by turning on the switches 39 and 40. By doing this, as shown in FIG.8, the electrostatic adhering force acting on the wafer 1 does not released when the pressure inside the etching treatment chamber 6 is controlled to the treating pressure before the etching treatment of the wafer 1. Therefore, in this case, the same effect as in the second embodiment can also be attained.

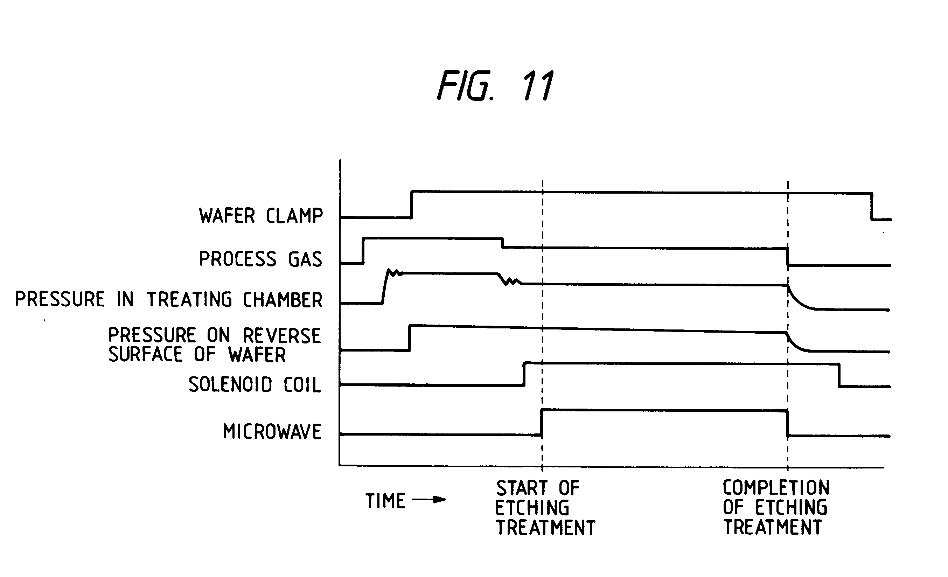

Description will be made below on the construction and etching method of a microwave etching apparatus with magnetic field to which a fourth embodiment according to the present invention is applied, referring to FIG.10 and FIG.11. The different point in this construction from that in the first and the second embodiments is that an O-ring 40 is provided in the periphery of surface of an etching electrode 39, the bottom electrode 15 being raised after the wafer 1 is mounted on the etching electrode 39, the wafer 1 during etching treatment being held with the wafer clamp 25. By doing this, as shown in the sequence in FIG.11, the etching treatment of the wafer 1 can be done by means of controlling the pressure inside the etching treatment chamber 6 to the treating pressure after the wafer 1 is held with the wafer clamp 25 in the same way as in the embodiments described above.

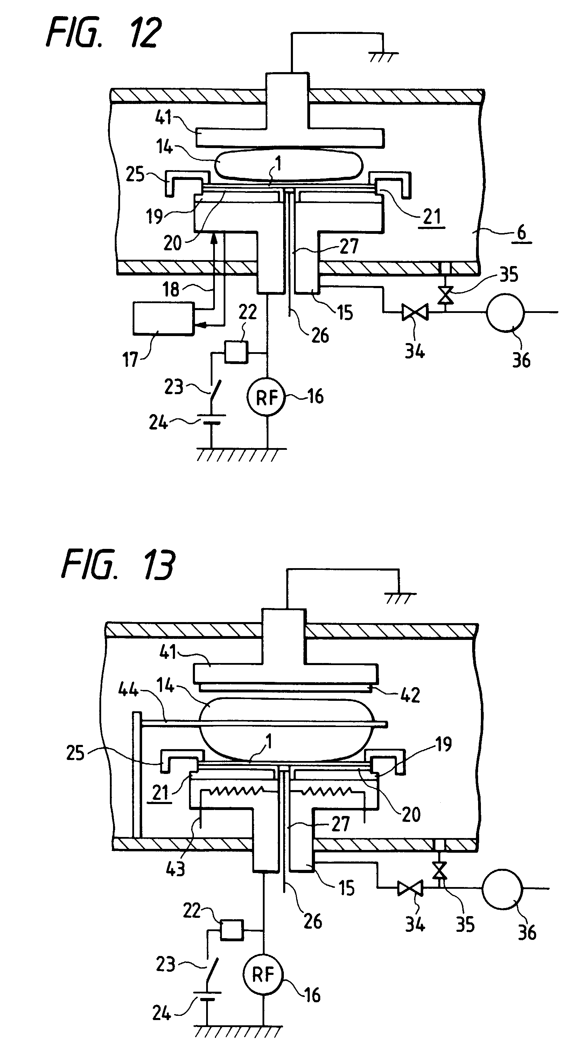

FIG.12 shows a fifth embodiment, as another etching apparatus, in which the present invention is applied to a parallel plain plate type reactive ion etching apparatus. The different point from the microwave etching apparatus with magnetic field is that there is provided an upper electrode 41 which is connected to the ground and facing against the bottom electrode 15, and high frequency current is applied to both of the electrodes with a high frequency power source 16 to produce plasma 14 instead of producing plasma 14 with the interaction of the microwave 12 and the magnetic field induced by the solenoid coil 13.

The different points among the first, the second and third embodiments are in the methods of plasma production. Therefore, the etching treatment can be also performed in the same way by forming the bottom electrode 15 in the same construction as in the embodiments described above.

FIG.13 shows the construction of a sixth embodiment in which the present invention is applied to a spatter apparatus. The spatter apparatus has a target 42 for forming film mounted on the upper electrode 41, a wafer 1 being mounted on the bottom electrode 15 which has a heater 43 for heating the wafer 1, high frequency current being applied between the upper electrode 41 and the bottom electrode 15 to produce plasma 14, and then a shutter 44 is opened to form a film of the target 42 on the surface of wafer 1. The different points from the etching apparatus are that the treatment pressure is further lower and the wafer 1 is treated while being heated. Therefore, the spattering treatment can be also performed in the same way as described above by forming the bottom electrode 15 in the same construction as in the first, the second and the third embodiments.

The construction of the reservoir to hold a part of the treating gas is not limited to the embodiments described above. For example, the construction of the reservoir may be such that a space having a certain volume is provided and a concave part opening to the surface of electrostatic adhering electrode, that is the surface exchanging heat with a wafer, is separately provided from the electrostatic adhering electrode 21.

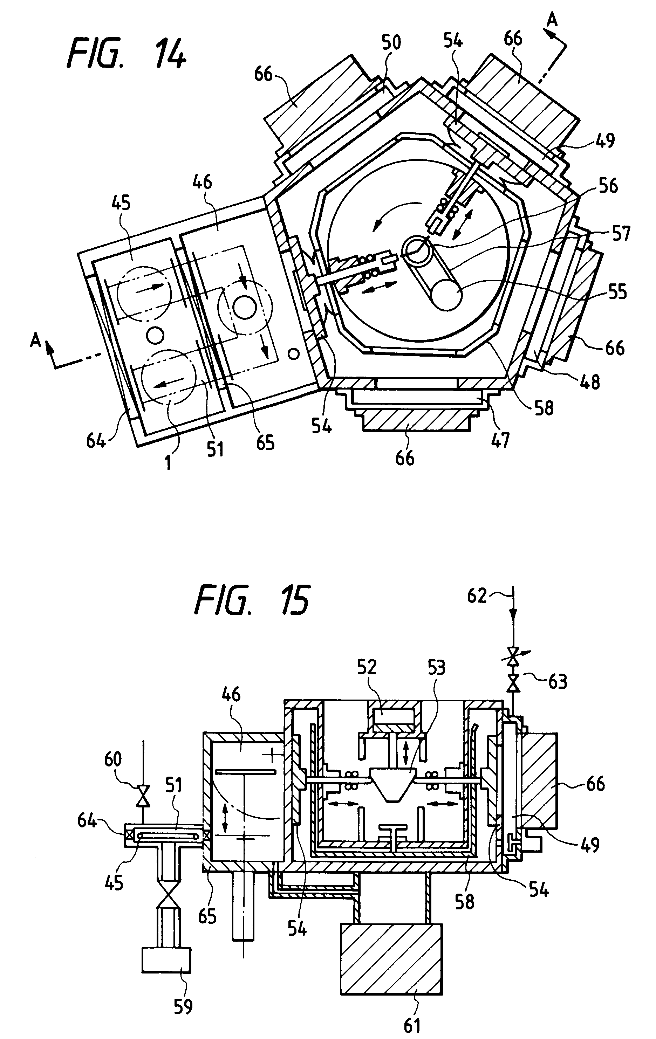

FIG.14 and 15 show the construction of a seventh embodiment in which the present invention is applied to a treatment apparatus having a plurality of treating chambers. FIG.15 is a cross-sectional view being taken on the plane of the line A-A in FIG.14. Explanation will be made on a case the present invention is applied to a spattering apparatus as an example of the apparatus.

The spattering apparatus comprises spare chambers: a wafer load/unload chamber 45, a loading chamber 46; and treating stations: a second treating station 47, a third treating station 48, a fourth treating station 49 and a fifth treating station 50. The apparatus also has a transfer mechanism 51 to transfer the wafer 1 between the both spare chambers, that are the wafer load/unload chamber 45 and the loading chamber 46. The apparatus has five sets of wafer holder 54 (wafer holders 54 in the second treating station 47, the third treating station 48 and the fifth treating station 50 are not shown in the figure) moving forward and backward toward the loading chamber 46 and the treating chambers (the stations from the second treating station 47 to the fifth treating station 50) by means of a circular cone cam 53 being moved upward and downward using an air cylinder 46. The apparatus has means for transferring the wafer which comprises a drum 58 driven by a motor 55, a gear 56 and a chain 57 to rotate the wafer holder 54 step-wise with a pitch between treating stations; a wafer chuck mechanism (not shown) to transfer the wafer 1 from the transfer mechanism 51 to the wafer holder 54 in the loading chamber 46. Furthermore, the apparatus has a vacuum pump 59 to evacuate the wafer load/unload chamber 45; a leak valve 60 to release the vacuum to the atmosphere; a vacuum pump 61 to evacuate the loading chamber 46 and the treating chambers from the second treating station 47 to the fifth treating station 50; a valve 63 to release the vacuum to the atmosphere or to introduce process gas 62 such as argon gas.

The wafer 1 to be treated is transferred through a gate valve 64 into the wafer load/unload chamber 45 having been released to the atmosphere by means of opening the leak valve 60. When the wafer load/unload chamber 45 is evacuated using the vacuum pump 59 and the pressure in the wafer load/unload chamber reaches approximately that in the loading chamber 46, a gate valve 65 is opened to transfer the wafer into the loading chamber 46 using the transfer mechanism 51.

In the loading chamber 46, the wafer 1 having been transferred from the wafer chuck mechanism to the wafer holder 54 is preformed given given-treatments at the stations between the second treating station 47 to the fifth treating station 50 by rotating the drum 58. Then the wafer 1 having treated is transferred through the loading chamber 46 to the wafer load/unload chamber 45 and is unloaded out of the wafer load/unload chamber 45 in the processes reverse to those described above.

At the stations between the second treating station 47 and the fifth treating station 50, the treatments are performed with arbitrary combination of wafer baking treatment to remove contamination gas absorbed on the surface of the wafer 1; spatter etching treatment to remove oxide layer on the surface of the wafer 1 before spattering; spattering treatment to form a thin film. In general, wafer baking treatment is performed at the second treating station 47, spatter etching at the third treating station 48, and spattering treatment at the fourth treating station 49 and the fifth treating station 50. In this case, treating units 66 at each of the stations are that the unit in the second treating station 47 is a wafer baking unit, in the third teaming station 48 being a spatter etching unit, in the fourth treating station 49 and in the fifth treating station 50 being spatter treating units.

In this embodiment, the wafer holder 54 has a structure to hold the wafer 1 with electrostatic adherence as shown in the second embodiment according to the present invention, and in the spare chamber, that is the loading chamber 46, process gas 62 such as argon or helium gas is enclosed on the reverse side surface of the wafer 1 through the same processes as those in the second embodiment. Then, the treating temperatures of the wafer 1 can be controlled by means of successively performing wafer baking treatment, spatter etching treatment and spattering treatment in the treating chambers.

As described above, the present invention can be widely applied to the temperature control of treated object in a treatment apparatus in which a specimen such as wafer is treated with plasma or the like in a reduced pressure environment while the specimen is being cooled or heated. It can be cited plasma etching, plasma chemical vapor deposition, spattering and so on as the examples of treating a treated object using plasma. It can be cited ion implantation, molecular beam epitaxy, vapor deposition, reduced pressure chemical vapor deposition and so on as the examples of treating a treated object not using plasma.

And it can be cited etching, ion implantation, spattering, ion milling, electron beam machining, lithography and so on as the examples of cooling a specimen. It can be cited chemical vapor deposition, molecular beam epitaxy, vapor deposition and so on as the examples of heating a specimen.

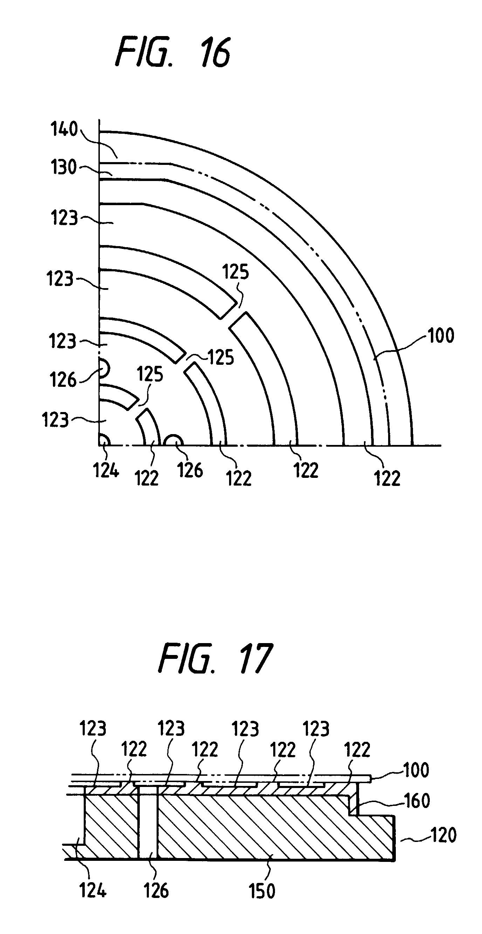

Explanation will be made below on the construction of a electrostatic adhering electrode to which an eighth embodiment according to the present invention is applied, referring to FIG.16 and FIG.17. The direction of the orientation flat 140 of a wafer 100 to be treated etching is adjusted in advance so as to engage to the orientation flat 130 of an electrostatic adhering electrode 120. Then the wafer is mounted on the electrostatic adhering electrode 120 constructed by forming an insulating film 160 of Al₂O₃ on the surface of an aluminum electrode 150 in an etching treating chamber. The electrostatic adhering electrode has an insulating film 160 which is formed by thermal splay of Al₂O₃ on the surface of an aluminum electrode 150 in a reduced pressure environment. Etching treatment of the wafer 100 is preformed in such a manner that the process gas introduced in a discharge tube is made into plasma with the interaction of microwave and the magnetic field induced by a solenoid coil, high frequency current being applied to an electrode fixing the electrostatic adhering electrode 120 with a high frequency power source to control the energy of ions to be implanted into the wafer 100.

After completion of etching treatment of the wafer 100, the wafer 100 is removed from the electrostatic adhering electrode 120 by means of raising a lift-up pin, and then transferred to another place by a transfer mechanism.

The electrostatic adhering electrode 120 has approximately the same outer diameter as the wafer 100, and has the orientation flat 130 in the periphery. And on the surface of the wafer 100, there are alternately arranged ring-shaped wafer contact portions 122 and ring-shaped wafer non-contact portions 123. The ring-shaped adhering portions attaches to the wafer 100, and the ring-shaped non-adhering portions are grooves having a depth of approximately 100µm. A reservoir 124 for storing helium gas is provided on the upper surface of the electrostatic adhering electrode 120 so as to open upward. Grooves 125 having depth of approximately 100µm are also provided on the upper surface of the electrostatic adhering electrode 120. The grooves 125 are flow passages through which the helium gas stored in the reservoir 124 flows toward the periphery of the electrostatic adhering electrode, and are also formed with ultrasonic machining. A hole for a lift-up pin 126, which is not shown in the figure, is sealed so that the helium gas may be leaked.

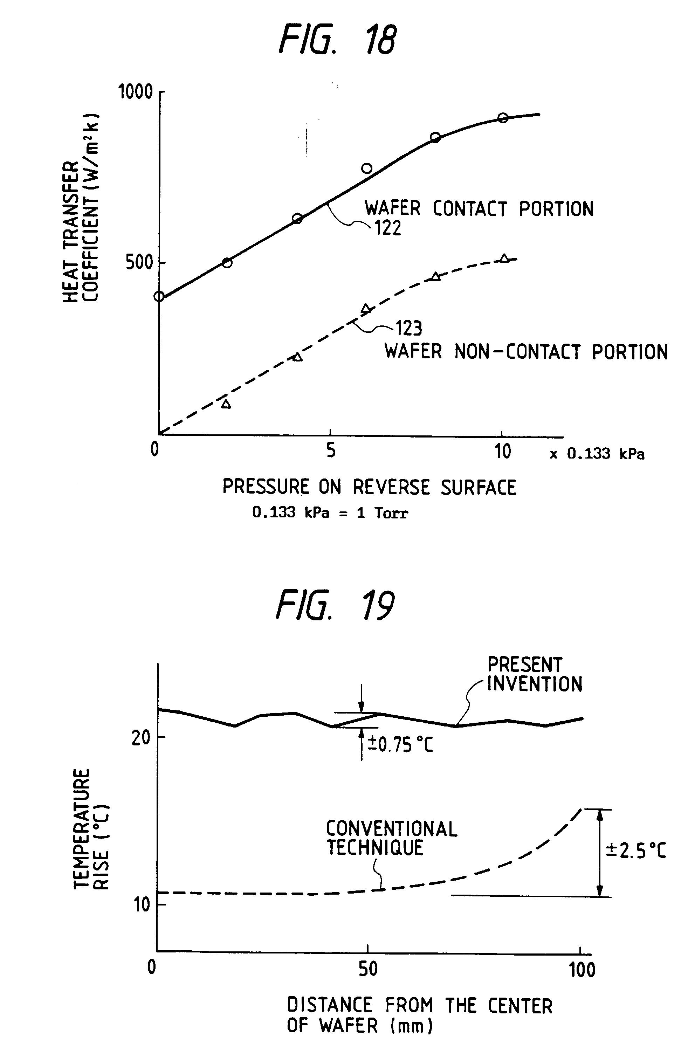

FIG.18 shows measured results of heat transfer coefficients between the wafer 100 and the electrostatic adhering electrode 120 in the wafer contact portion 122 and the wafer non-contact portion 123. Although both of the heat transfer coefficients in the wafer contact portion 122 and in the wafer non-contact portion 123 are increased with increase in the pressure on the reverse side surface, the heat transfer coefficient in the wafer contact portion 122 is larger than that in the non-adhering portion 123. When the pressure on the reverse side surface is approximately 4 Torr, the heat transfer coefficients in the wafer contact portion and in the wafer non-contact portion are approximately 600W/m²K and approximately 200W/m²K respectively.

FIG.19 shows calculated results of temperature distributions in the radial direction of the wafer 100 for a conventional technique and for the present invention during etching treatment based on the results described above. In these calculations, it is assumed that the wafer size has a diameter of 20 cm (8 inches), the heat input to the wafer being 200W, the heat transfer coefficient in the adhering portion 122 being 600 W/m²K, the heat transfer coefficient in the non-adhering portion 123 being 200 W/m²K, the heat transfer coefficient in the non-adhering portion on the periphery of the wafer being 0 W/m²K.

In the conventional technique, the temperature rise is large since the adiabatic area of the wafer in the periphery is large, and the temperature difference becomes ±2.5°C. On the other hand, in the present invention, although the average temperature is higher, the temperature distribution alternately changes high and low in the direction of the radius and the temperature difference is decreased to ±0.75°C.

With varying the heat transfer coefficient between the wafer 100 and the electrostatic adhering electrode 120 by means of forming high heat transfer coefficient portions and low heat transfer coefficient portions alternately, the temperature distribution across the wafer 100 can be flattened. The same effect can be obtained with varying electrostatic adhering force by means of alternately varying the surface roughness of the insulating film 160 large and small or by means of alternately varying the film materials of the insulating film 160. Although it has been described in the embodiment that helium gas is enclosed in the reservoir 124, the same effect can be obtained when the other kind of gas is used.

According to the present invention, in a method of treating a treated object in a reduced pressure environment, it can be realized easily performing the temperature control of the treated object and simplifying its electrode construction.

Further, according to the present invention, the temperature distribution across a treated object treated in a reduced pressure environment can be made more uniform.

## Claims

1. Apparatus for treating a wafer in a reduced pressure environment, said apparatus comprising a treatment chamber (6) which can be evacuated and supplied with a gaseous medium (11) suitable for wafer treatment; a pedestal (15) in said treatment chamber (6) for receiving the waver to be treated, said pedestal (15) forming an electrode and having on its upper surface in opposed relationship to the positioned wafer (1) an electrostatic adhering electrode (21) which is constructed by means of forming an insulating film (20) on an electrode (19); and the pedestal having a spatial reservoir (27, 28, 29) which has in the rest position when the wafer (1) is not positioned equal pressure with the treatment chamber (6),
characterized by
means (2, 7) for transferring the wafer (1) from a load cassette (3) passed said treatment chamber (6) to an unload cassette (9);
means for maintaining a process gas (11) in the treatment chamber (6) at a pressure higher than a pressure for treating the wafer;
means for filling said spatial reservoir (27, 28, 29) with the process gas (11) having a pressure higher than the pressure for treating the wafer when the wafer (1) is electrostatically adhered to the electrode (21), and for maintaining said process gas (11) in the treatment chamber (6) at a pressure higher than the pressure for treating the wafer; and
means for depressurizing the pressure in the treatment chamber (6) to the pressure for treating the wafer;
wherein, when the wafer (1) is positioned and electrostatically adhered to said electrostatic adhering electrode (21), said spatial reservoir (27, 28, 29) is sealed at one end to the treatment chamber (6) by means of an 0-ring (31) and at the other end by means of the wafer (1) which is electrostatically adhered to the electrode (21), so that the gas contained in said spatial reservoir (27, 28, 29) substantially maintains its pressure while the treatment chamber (6) is further evacuated to lower pressure required for the wafer treatment, said gas contained in said spatial reservoir (27, 28, 29) serving as heat transfer medium between said wafer (1) and said pedestal (15).

2. The apparatus of claim 1 being a plasma treatment apparatus for treating a wafer (1) with plasma.

3. The apparatus of claim 1 for treating a wafer (1) with ion implantation.

4. The apparatus of claim 1 being a molecular beam epitaxy treatment apparatus for treating a wafer (1) with molecular beam epitaxy.

5. The apparatus of claim 1, wherein said electrostatic adhering electrode (21) has radially extended grooves (28, 29) on its surface and a hole (27) for a pin (26) for lifting up the wafer (1), and said reservoir is formed by said hole (27) and said grooves (28, 29) and substantially extends between said wafer (1) and the space that is formed (28, 29) on said electrostatic adhering electrode (21) to the gap between said pin (26) and said hole (27).

6. The apparatus of claim 1, wherein said reservoir (27, 28, 29) mounted on said pedestal (15) is opened to the surface of the electrostatic adhering electrode (21).

7. The apparatus of claim 2 for holding a wafer to be treated with plasma by electrostatic adhering force between the wafer (1) and said insulating film (20), characterized in that the heat transfer coefficient between the wafer (1) and the insulating film (20) has a non-uniform distribution.

8. The apparatus of claim 7, wherein the non-uniform distribution in the heat--transfer coefficient is produced by means of forming contact portions and non-contact portions on the wafer (1) alternately by varying the gap between the wafer (1) and the insulating film (20).

9. The apparatus of claim 7, wherein the non-uniform distribution in the heat transfer coefficient is produced by means of forming large roughness portions and small roughness portions alternately on the surface of the insulating film (20).

10. The apparatus of claim 7, wherein the non-uniform distribution in the heat transfer coefficient is produced by means of forming the insulating film (20) using different kinds of materials alternately.

11. The apparatus of claim 8, wherein the gap between the wafer (1) and the insulating film (20) is formed by ultrasonic machining.

12. The apparatus of claim 1, characterized in that said pedestal (15) is provided with an exhausting outlet (33) which connects to the hole (27) of said reservoir in order to evacuate the treatment chamber (6) by using a vacuum pump (36) through a first valve (35) directly coupled to the treatment chamber (6) by means of opening a second valve (34) which is connected to said exhausting outlet (33).

13. The apparatus of claim 1, characterized in that a wafer clamp (25) is provided for fixing the periphery of the wafer (1) when the pedestal (15) is lifted up, and that a current source is provided for applying direct current to both sides of said insulated film (20) to produce the electrostatic adhering force.

14. The apparatus of claim 1, wherein helium gas is used as heat transfer medium and the gas pressure in said reservoir is maintained at 1.33 kPa (10 Torr).

15. Method for treating a wafer in a reduced pressure environment in a treating apparatus comprising a hermetic treatment chamber (6) which can be evacuated and supplied with a gaseous medium (11) suitable for the wafer treatment; a pedestal (15) in said treatment chamber (6) for receiving the waver to be treated, said pedestal (15) forming an electrode and having on its upper surface in opposed relationship to the positioned wafer (1) an electrostatic adhering electrode (21) which is constructed by means of forming an insulating film (20) on an electrode (19); and the pedestal (15) having a spatial reservoir (27, 28, 29) which has in the rest position when the wafer (1) is not positioned equal pressure with the treatment chamber (6), wherein the wafer (1) is positioned on said pedestal (15) in opposed relationship to said electrostatic adhering electrode on said insulating film (20), a gaseous medium (11) is supplied to the treatment chamber (6) thereby maintaining a first predetermined gas pressure of equal value within the treatment chamber (6) and in said spatial reservoir (27, 28, 29),
characterized by the following steps:
- transferring the wafer (1) from a load cassette (3) by driving means (2, 7) to the treatment chamber (6) filled with the process gas (11);
- maintaining the process gas (11) in the treatment chamber (6) at a pressure higher than the pressure for treating the wafer (1);
- filling said spatial reservoir (27, 28, 29) with the process gas (11) having a pressure higher than the pressure for treating the wafer (1) when in the next step the wafer is electrostatically adhered to the electrode (21);
- activating said electrode (21) to produce the electrostatic adhering force between the wafer (1) and said insulating film (20) to the effect that the gaseous medium contained in said reservoir (27, 28, 29) under said first predetermined gas pressure is sealed from said treatment chamber (6) at one end by means of an 0-ring (31) and at the other end by means of the wafer (1) which is electrostatically adhered to said electrode (21);
- depressurizing the pressure in the treatment chamber (6) to the pressure for treating the wafer (1);
wherein said gaseous medium contained in said reservoir (27, 28, 29) and maintained at said first predetermined gas pressure level serves as heat transfer medium between said wafer (1) and said pedestal (15) during the waver treating process; and
- after the wafer treating process is finished, transferring the waver (1) from the treatment chamber (6) by driving means to an unload cassette (9).

16. The method of claim 15, wherein heat is transmitted between said wafer (1) and said pedestal (15) using said gas which is enclosed in said reservoir (27, 28, 29) and maintained at said first predetermined gas pressure, and wherein said wafer (1) is treated under said second predetermined gas pressure maintained in said treatment chamber (6).

17. The method of claim 15 being a plasma treatment method for treating a wafer (1) with plasma.

18. The method of claim 15 for treating a wafer (1) with ion implantation.

19. The method of claim 15 being a molecular beam epitaxy treatment method for treating a wafer (1) with molecular beam epitaxy.

20. The method of claim 17, wherein the heat generated in the wafer (1) by the plasma treatment is transmitted to said pedestal (15) using said gas enclosed in said reservoir (27, 28, 29).

21. The method of claim 15, wherein said pedestal (15) comprises an electrostatic adhering electrode (21) having grooves (28, 29) on its surface and a hole (27) for a pin (26) for lifting up the wafer (1), and a gaseous medium enclosed in said reservoir (27, 28, 29) between said wafer (1) and the space that is formed from the grooves (28, 29) on said electrostatic adhering electrode (21) to the gap between said lift-up pin (26) and said hole (27).

22. The method according to any one of the above claims 15 through 21,wherein said first predetermined gas pressure is 1.33 kPa (10 Torr) or higher and is also higher than the second predetermined gas pressure which is the wafer treating pressure.

## Patentansprüche

1. Vorrichtung zum Behandeln eines Wafers in einer Umgebung mit reduziertem Druck, wobei die Vorrichtung eine Behandlungskammer (6) aufweist, die evakuiert und mit einem gasförmigen Medium (11) versorgt werden kann, das für eine Behandlung eines Wafers geeignet ist, und einen Sockel (15) in der Behandlungskammer (6) zum Aufnehmen des zu behandelnden Wafers, wobei der Sockel (15) eine Elektrode bildet und auf seiner oberen Oberfläche in gegenüberliegender Beziehung zu dem positionierten Wafer (1) eine elektrostatische haftende Elektrode (21) aufweist, die durch Bilden eines isolierenden Films (20) auf einer Elektrode (19) aufgebaut ist, und wobei der Sockel ein räumliches Reservoir (27, 28, 29) aufweist, das in der Ruheposition, wenn der Wafer (1) nicht positioniert ist, einen gleichen Druck wie die Behandlungskammer (6) aufweist,
gekennzeichnet durch
Einrichtungen (2, 7) zum Übertragen des Wafers (1) von einer Ladekassette (3) über die Behandlungskammer (6) zu einer Entladekassette (9);
Einrichtungen zum Halten eines Verfahrensgases (11) in der Behandlungskammer (6) bei einem Druck, der höher als ein Druck zum Behandeln des Wafers ist;
Einrichtungen zum Füllen des räumlichen Reservoirs (27, 28, 29) mit dem Verfahrensgas (11), das einen Druck aufweist, der höher als der Druck zum Behandeln des Wafers ist, wenn der Wafer (1) elektrostatisch an die Elektrode (21) gehaftet ist, und zum Halten des Verfahrensgases (11) in der Behandlungskammer (6) bei einem Druck, der höher als der Druck zum Behandeln des Wafers ist; und
Einrichtungen zum Verringern des Druckes in der Behandlungskammer (6) auf den Druck zum Behandeln des Wafers;
wobei, wenn der Wafer (1) an der elektrostatischen haftenden Elektrode (21) positioniert und elektrostatisch angehaftet ist, das räumliche Reservoir (27, 28, 29) an einem Ende der Behandlungskammer (6) mit Hilfe eines O-Ringes (31) abgedichtet ist, und an dem anderen Ende mittels des Wafers (1), der elektrostatisch an die Elektrode (21) angehaftet ist, so daß das Gas, das in dem räumlichen Reservoir (27, 28, 29) enthalten ist, im wesentlichen seinen Druck hält, während die Behandlungskammer (6) weiter auf einen niedrigeren Druck evakuiert wird, der für die Waferbehandlung erforderlich ist, wobei das Gas, das in dem räumlichen Reservoir (27, 28, 29) enthalten ist, als Wärmeübertragungsmedium zwischen dem Wafer (1) und dem Sockel (15) dient.

2. Vorrichtung gemäß Anspruch 1, die eine Plasma-Behandlungsvorrichtung zum Behandeln eines Wafers (1) mit Plasma ist.

3. Vorrichtung gemäß Anspruch 1 zum Behandeln eines Wafers (1) mit einer lonenimplantation.

4. Vorrichtung gemäß Anspruch 1, die ein Molekularstrahl-Epitaxy-Behandlungvorrichtung zum Behandeln eines Wafers (1) mit einer Molekularstrahl-Epitaxie ist.

5. Vorrichtung gemäß Anspruch 1, wobei die elektrostatische haftende Elektrode (21) radial sich erstreckende Nute (28, 29) auf ihrer Oberfläche und ein Loch (27) für ein Stift (26) zum Hochheben des Wafers (1) aufweist und wobei das Reservoir durch das Loch (27) und die Nute (28, 29) gebildet ist und sich im wesentlichen zwischen dem Wafer (1) und dem Raum erstreckt, der (28, 29) auf der elektrostatischen haftenden Elektrode (21) bis zu dem Spalt zwischen dem Stift (26) und dem Loch (27) gebildet ist.

6. Vorrichtung gemäß Anspruch 1, bei dem das Reservoir (27, 28, 29), das auf dem Sockel (15) montiert ist, zu der Oberfläche der elektrostatischen haftenden Elektrode (21) hin geöffnet ist.

7. Vorrichtung gemäß Anspruch 2 zum Halten eines Wafers, der mit Plasma behandelt werden soll, durch eine elektrostatische Haftkraft zwischen dem Wafer (1) und dem isolierenden Film (20), dadurch gekennzeichnet, daß der Wärmeübertragungskoeffizienten zwischen dem Wafer (1) und dem isolierenden Film (20) eine nicht-gleichförmige Verteilung aufweist.

8. Vorrichtung gemäß Anspruch 7, bei der die nicht-gleichförmige Verteilung in dem Wärmeübertragungskoeffizienten mittels des Bildens von Kontaktabschnitten und Nicht-Kontaktabschnitten auf dem Wafer (1) abwechselnd durch Variieren des Spaltes zwischen dem Wafer (1) und dem isolierenden Film (20) erzeugt ist.

9. Vorrichtung gemäß Anspruch 7, bei der die nicht-gleichförmige Verteilung in dem Wärmeübertragungskoeffizienten durch Bilden von großen Rauhigkeitsabschnitten und kleinen Rauhigkeitsabschnitten abwechselnd auf der Oberfläche des isolierenden Films (20) erzeugt ist.

10. Vorrichtung gemäß Anspruch 7, bei der die nicht-gleichförmige Verteilung in dem Wärmeübertragungskoeffizienten durch Bilden des isolierenden Filmes (20) und der Verwendung von unterschiedlichen Arten von Materialien abwechselnd erzeugt ist.

11. Vorrichtung gemäß Anspruch 8, bei der der Spalt zwischen dem Wafer (1) und dem isolierenden Film (20) durch Ultraschalbearbeitung gebildet ist.

12. Vorrichtung gemäß Anspruch 1, dadurch gekennzeichnet, daß der Sockel (15) mit einem Absaugauslaß (33) versehen ist, der mit dem Loch (27) des Reservoirs verbunden ist, um die Behandlungskammer (6) durch Verwendung einer Vakuumpumpe (36) über ein erstes Ventil (35) zu evakuieren, das direkt an die Behandlungskammer (6) durch Öffnen eines zweiten Ventils (34) gekoppelt ist, das mit dem Absaugauslaß (33) verbunden ist.

13. Vorrichtung gemäß Anspruch 1, dadurch gekennzeichnet, daß eine Waferklammer (25) zum Befestigen der Peripherie des Wafers (1) bereitgestellt ist, wenn der Sockel (15) hochgehoben ist, und daß eine Stromquelle bereitgestellt ist, um einen Gleichstrom an beide Seiten des isolierenden Films (20) anzulegen, um die elektrostatische haftende Kraft zu erzeugen.

14. Vorrichtung gemäß Anspruch 1, bei der Heliumgas als Wärmeübertragungsmedium verwendet wird und wobei der Gasdruck in dem Reservoir auf 1,33 kPa (10 Torr) gehalten ist.

15. Verfahren zum Behandeln eines Wafers in einer Umgebung mit reduziertem Druck in einer Behandlungsvorrichtung, das aufweist: eine hermetische Behandlungskammer (6), die evakuiert und mit einem gasförmigen Medium (11) versorgt werden kann, das für die Behandlung des Wafers geeignet ist; einen Sockel (15) in der Behandlungskammer (6) zum Aufnehmen des Wafers, der behandelt werden soll, wobei der Sockel (15) eine Elektrode bildet und auf seiner oberen Oberfläche in entgegengesetzter Beziehung zu dem positionierten Wafer (1) eine elektrostatische haftende Elektrode (21) aufweist, die durch Bilden eines isolierenden Films (20) auf einer Elektrode (19) aufgebaut ist; und wobei der Sockel (15) ein räumliches Reservoir (27, 28, 29) aufweist, das in der Ruheposition, wenn der Wafer (1) nicht positioniert ist, einen gleichen Druck wie die Behandlungskammer (6) aufweist, wobei der Wafer (1) auf dem Sockel (15) in entgegengesetzter Beziehung zu der elektrostatischen haftenden Elektrode auf dem isolierenden Film (20) positioniert ist, wobei ein gasförmiges Medium (11) zu der Behandlungskammer (6) geliefert wird, wodurch ein erster vorbestimmter Gasdruck von gleichem Wert in der Behandlungskammer (6) und in dem räumlichen Reservoir (27, 28, 29) gehalten wird,
gekennzeichnet durch die folgenden Schritte:
- Übertragen des Wafers (1) von einer Ladekassette (3) durch Antriebseinrichtungen (2, 7) zu der Behandlungskammer (6), die mit dem Verfahrensgas (11) gefüllt ist;
- Halten des Verfahrensgases (11) in der Behandlungskammer (6) auf einem Druck, der höher als der Druck zum Behandeln des Wafers (1) ist:
- Füllen des räumlichen Reservoirs (27, 28, 29) mit dem Verfahrensgas (11), das einen Druck aufweist, der höher als der Druck zum Behandeln des Wafers (1) ist, wenn in dem nächsten Schritt der Wafer elektrostatisch an die Elektrode (21) gehaftet ist;
- Aktivieren der Elektrode (21), um die elektrostatische Haftkraft zwischen dem Wafer (1) und dem isolierenden Film (20) zu erzeugen, mit der Wirkung, daß das gasförmige Medium, das in dem Reservoir (27, 28, 29) unter dem ersten vorbestimmten Gasdruck enthalten ist, von der Behandlungskammer (6) an einem Ende durch einen O-Ring (31) und an dem anderen Ende durch den Wafer (1) abgedichtet ist, der elektrostatisch an die Elektrode (21) gehaftet ist;
- Verringern des Druckes in der Behandlungskammer (6) auf den Druck zum Behandeln des Wafers (1);
wobei das gasförmige Medium, das in dem Reservoir (27, 28, 29) enthalten ist und auf dem ersten vorbestimmten Gasdruckpegel gehalten ist, als Wärmeübertragungsmedium zwischen dem Wafer (1) und dem Sockel (15) während dem Waferbehandlungsverfahren dient; und
- Übertragen des Wafers (1) von der Behandlungskammer (6) durch Antriebseinrichtungen zu einer Entladekassette (9), nachdem das Waferbehandlungsverfahren beendet ist.

16. Verfahren gemäß Anspruch 15, bei dem Wärme zwischen dem Wafer (1) und dem Sockel (15) unter Verwendung des Gases übertragen wird, das in dem Reservoir (27, 28, 29) eingeschlossen ist und auf dem ersten vorbestimmten Gasdruck gehalten wird, und wobei der Wafer (1) unter dem zweiten vorbestimmten Gasdruck behandelt wird, der in der Behandlungskammer (6) gehalten ist.

17. Verfahren gemäß Anspruch 15, das ein Plasmabehandlungsverfahren zum Behandeln eines Wafers (1) mit Plasma ist.

18. Verfahren gemäß Anspruch 15 zum Behandeln eines Wafers (1) mit lonenimplantation.

19. Verfahren gemäß Anspruch 15, das ein Molekularstrahl-Epitaxie-Behandlungsverfahren zum Behandeln eines Wafers (1) mit Molekularstrahl-Epitaxie ist.

20. Verfahren gemäß Anspruch 17, bei dem die Wärme, die in dem Wafer (1) durch die Plasmabehandlung erzeugt wird, an den Sockel (15) unter Verwendung des Gases übertragen wird, das in dem Reservoir (27, 28, 29) eingeschlossen ist.

21. Verfahren gemäß Anspruch 15, bei dem der Sockel (15) eine elektrostatische haftende Elektrode (21) aufweist, die Nute (28, 29) auf ihrer Oberfläche und ein Loch (27) für ein Stift (26) zum Hochheben des Wafers (1) aufweist, und ein gasförmiges Medium, das in dem Reservoir (27, 28, 29) zwischen dem Wafer (1) und dem Raum eingeschlossen ist, der durch die Nute (28, 29) auf der elektrostatisch haftenden Elektrode (21) bis zu dem Spalt zwischen dem Stift zum Hochheben (26) und dem Loch (27) gebildet ist.

22. Verfahren gemäß einem der obigen Ansprüche 15 bis 21, wobei der erste vorbestimmte Gasdruck 1,33 kPa (10 Torr) oder höher ist und auch höher ist, als der zweite vorbestimmte Gasdruck, der der Waferbehandlungsdruck ist.

## Revendications

1. Appareil pour traiter une tranche dans un environnement à pression réduite, ledit appareil comprenant une chambre de traitement (6) qui peut être mise sous vide et alimentée avec un milieu gazeux (11) approprié pour traitement de tranches, un support (15) dans ladite chambre de traitement (6) pour recevoir la tranche à traiter, le support (15) formant une électrode et ayant sur sa surface supérieure en relation opposée à la tranche positionnée (1) une électrode électrostatique adhérente (21) réalisée par un moyen de formation d'un film isolant (20) sur une électrode (19), et le support ayant un réservoir spatial (27, 28, 29) présentant dans la position de repos quand la tranche (1) n'est pas positionnée, une pression égale à la chambre de traitement (6),
caractérisé par
des moyens (2, 7) pour transférer la tranche (1) d'une cassette de chargement (3) au travers de ladite chambre de traitement (6) vers une cassette de déchargement (9) ;
des moyens pour maintenir un gaz de traitement (11) dans la chambre de traitement (6) à une pression plus haute que la pression pour traiter la tranche ;
des moyens pour remplir ledit réservoir spatial (27, 28, 29) avec le gaz de traitement (11) ayant une pression plus haute que la pression pour traiter la tranche si la tranche (1) adhère électrostatiquement à l'électrode (21), et pour maintenir le gaz de traitement (11) dans la chambre de traitement (6) à une pression plus haute que la pression pour traiter la tranche ; et
des moyens pour dépressuriser la pression dans la chambre de traitement (6) à la pression pour traiter la tranche ;
dans lequel, quand la tranche (1) est positionnée et adhère électrostatiquement à ladite électrode électrostatique adhérente (21), ledit réservoir spatial (27, 28, 29) est étanchéifié à une extrémité vers la chambre de traitement (6) à l'aide d'un joint torique (31) et à l'autre extrémité à l'aide d'une tranche (1) adhérant électrostatiquement à l'électrode (21) d'une façon telle que le gaz contenu dans le réservoir spatial (27, 28, 29) maintient substantiellement sa pression pendant que la chambre de traitement (6) est mise sous vide encore plus à une pression encore plus basse, nécessaire pour le traitement de la tranche, ledit gaz contenu dans le réservoir spatial (27, 28, 29) servant de milieu de transmission thermique entre ladite tranche (1) et ledit support (15).

2. Appareil selon la revendication 1, étant un appareil de traitement à plasma pour traiter une tranche (1) avec du plasma.

3. Appareil selon la revendication 1, pour traiter une tranche (1) avec une implantation ionique.

4. Appareil selon la revendication 1, étant un appareil de traitement épitaxial à faisceau moléculaire pour traiter une tranche (1) avec une épitaxie à faisceau moléculaire.

5. Appareil selon la revendication 1, caractérisé en ce que l'électrode électrostatique adhérente (21) a des rainures (28, 29) s'étendant radialement sur sa surface et un trou (27) pour une broche (26) pour soulever la tranche (1), et en ce que ledit réservoir est formé par le trou (27) et lesdites rainures (28, 29) et s'étendant substantiellement entre ladite tranche (1) et l'espace formé (28, 29) sur ladite électrode électrostatique adhérente (21) jusqu'à l'espace entre la broche (26) et le trou (27).

6. Appareil selon la revendication 1, caractérisé en ce que ledit réservoir (27, 28, 29) monté sur le support (15) est ouvert vers la surface de l'électrode électrostatique adhérente (21).

7. Appareil selon la revendication 2, pour retenir une tranche à traiter avec du plasma par une force électrostatique adhérente entre la tranche (1) et ledit film isolant (20), caractérisé en ce que le coefficient de transmission thermique entre la tranche (1) et le film isolant (20) a une distribution non uniforme.

8. Appareil selon la revendication 7, caractérisé en ce que la distribution non uniforme du coefficient de transmission thermique est produite par un moyen de formation de régions de contact et de régions sans contact sur la tranche (1) en alternance en faisant varier l'intervalle entre la tranche (1) et le film isolant (20).

9. Appareil selon la revendication 7, caractérisé en ce que la distribution non uniforme du coefficient de transmission thermique est produite par un moyen de formation de régions de rugosité larges et de régions de petite rugosité en alternance sur la surface du film isolant (20).

10. Appareil selon la revendication 7, caractérisé en ce que la distribution non uniforme du coefficient de transmission thermique est produite par un moyen de formation du film isolant (20) en utilisant différents types de matériaux en alternance.

11. Appareil selon la revendication 8, caractérisé en ce que l'intervalle entre la tranche (1) et le film isolant (20) est formé par un usinage ultrasonique.

12. Appareil selon la revendication 1, caractérisé en ce que le support (15) est pourvu d'une sortie aspirante (33) connectée au trou (27) du réservoir afin de faire le vide dans la chambre de traitement (6) en utilisant une pompe à vide (36) au travers d'une première valve (35) directement couplée à la chambre de traitement (6) par un moyen d'ouverture d'une deuxième valve (34) connectée à la sortie aspirante (33).

13. Appareil selon la revendication 1, caractérisé en ce qu'un serrage (25) de tranche est prévu pour fixer la périphérie de la tranche (1) quand le support (15) est surélevé, et en ce qu'une source de courant est prévue pour appliquer un courant continu aux deux côtés du film isolé (20) pour produire la force électrostatique adhérente.

14. Appareil selon la revendication 1, caractérisé en ce qu'un gaz hélium est utilisé comme milieu de transmission thermique et en ce que la pression de gaz dans ledit réservoir est maintenue à 1,33 kPa (10 Torr).

15. Procédé pour traiter une tranche dans un environnement à pression réduit dans un appareil de traitement comprenant une chambre de traitement hermétique (6) qui peut être mise sous vide et alimentée avec un milieu gazeux (11) approprié pour le traitement de tranche, un support (15) dans la chambre de traitement (6) pour recevoir la tranche à traiter, ledit support (15) formant une électrode et ayant sur sa surface supérieure en relation opposée à la tranche positionnée (1) une électrode électrostatique adhérente (21) réalisée par un moyen de formation d'un film isolant (20) sur une électrode (19), et le support (15) ayant un réservoir spatial (27, 28, 29) présentant dans la position de repos, quand la tranche (I) n'est pas positionnée, une pression égale à la chambre de traitement (6), la tranche (1) étant positionnée sur le support (15) dans une relation opposée à l'électrode électrostatique adhérente sur le film isolant (20), un milieu gazeux (11) est fourni à la chambre de traitement (6) en maintenant une première pression de gaz prédéterminée d'une valeur égale dans la chambre de traitement (6) et dans le réservoir spatial (27, 28, 29),
caractérisé par les étapes suivantes :
- on transfère la tranche (1) d'une cassette de chargement (3) par des moyens d'entraînement (2, 7) vers une chambre de traitement (6) remplie avec le gaz de traitement (11) ;
- on maintient le gaz de traitement (11) dans la chambre de traitement (6) à une pression plus haute que la pression pour traiter la tranche (1) ;
- on remplit le réservoir spatial (27, 28, 29) avec un gaz de traitement (11) ayant une pression plus haute que la pression pour traiter la tranche (1) si à l'étape suivante la tranche est adhère électrostatiquement à l'électrode (21) ;
- on active ladite électrode (21) pour produire la force électrostatique adhérente entre la tranche (1) et le film isolant (20) afin que le milieu gazeux contenu dans ledit réservoir (27, 28, 29) sous une première pression de gaz prédéterminée est étanche par rapport à la chambre de traitement (6) à une extrémité à l'aide d'un joint torique (31) et à l'autre extrémité à l'aide d'une tranche (1) adhère électrostatiquement à l'électrode (21) ;
- on dépressurise la pression dans la chambre de traitement (6) à la pression pour traiter la tranche (1) ;
le milieu gazeux contenu dans ledit réservoir (27, 28, 29) et maintenu à un premier niveau de pression de gaz prédéterminé sert comme milieu de transmission thermique entre la tranche (1) et le support (15) pendant la procédure de traitement de la tranche ; et
- après que la procédure de traitement de tranche soit terminée, on transfère la tranche (1) de la chambre de traitement (6) par les moyens d'entraînement vers une cassette de déchargement (9).

16. Procédé selon la revendication 15, caractérisé en ce que la chaleur est transmise entre la tranche (1) et le support (15) en utilisant le gaz inclus dans ledit réservoir (27, 28, 29) qui est maintenu à ladite première pression de gaz prédéterminée, et en ce que la tranche (1) est traitée sous une deuxième pression de gaz prédéterminée maintenue dans ladite chambre de traitement (6).

17. Procédé selon la revendication 15, étant un procédé de traitement à plasma pour traiter une tranche (1) avec du plasma.

18. Procédé selon la revendication 15, pour traiter une tranche (1) avec une implantation ionique.

19. Procédé selon la revendication 15, étant un procédé de traitement à épitaxie à faisceau moléculaire pour traiter une tranche (1) avec une épitaxie à faisceau moléculaire.

20. Procédé selon la revendication 17, caractérisé en ce que la chaleur générée dans la tranche (1) par le traitement à plasma est transmise au support (15) en utilisant le gaz inclus dans ledit réservoir (27, 28, 29).

21. Procédé selon la revendication 15, caractérisé en ce que le support (15) comprend une électrode adhérente électrostatique (21) ayant de rainures (28 ,29) sur sa surface et un trou (27) pour une broche (26) pour soulever la tranche (1), et un milieu gazeux inclus dans le réservoir (27, 28, 29) entre la tranche (1) et l'espace formé depuis les rainures (28, 29) sur ladite électrode électrostatique adhérente (21) jusqu'à l'espace entre la broche de soulèvement (26) et le trou (27).

22. Procédé selon une quelconque des revendications précédentes 15 à 21, caractérisé en ce que la première pression de gaz prédéterminée est de 1,33 kPa (10 Torr) ou plus haut et qu'elle est aussi plus haute que la deuxième pression de gaz prédéterminée qui est la pression de traitement de la tranche.
